(19) Europäisches Patentamt
European Patent Office
Office européen des brevets

(11) **EP 2 460 204 B1**

(12) **EUROPÄISCHE PATENTSCHRIFT**

(45) Veröffentlichungstag und Bekanntmachung des Hinweises auf die Patenterteilung:
**22.01.2020   Patentblatt 2020/04**

(21) Anmeldenummer: **10732974.0**

(22) Anmeldetag: **15.07.2010**

(51) Int Cl.:
**H01L 51/52** *(2006.01)*

(86) Internationale Anmeldenummer:
**PCT/EP2010/060250**

(87) Internationale Veröffentlichungsnummer:
**WO 2011/012461 (03.02.2011 Gazette 2011/05)**

(54) **ELEKTRONISCHES BAUELEMENT**

ELECTRONIC COMPONENT

COMPOSANT ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **27.07.2009   DE 102009034822**

(43) Veröffentlichungstag der Anmeldung:
**06.06.2012   Patentblatt 2012/23**

(73) Patentinhaber: **OSRAM OLED GmbH**
**93049 Regensburg (DE)**

(72) Erfinder:
• **BECKER, Dirk**
**84085 Langquaid (DE)**
• **DOBBERTIN, Thomas**
**93051 Regensburg (DE)**
• **REUSCH, Thilo**
**93055 Regensburg (DE)**
• **LANG, Erwin**
**93051 Regensburg (DE)**

(74) Vertreter: **Epping - Hermann - Fischer Patentanwaltsgesellschaft mbH Postfach 20 07 34 80007 München (DE)**

(56) Entgegenhaltungen:
**EP-A1- 1 701 395        EP-A2- 1 939 954**
**EP-A2- 2 012 375        JP-A- 2003 288 993**
**JP-A- 2006 337 447      US-A1- 2008 105 299**

EP 2 460 204 B1

**Beschreibung**

Die vorliegende Erfindung betrifft ein elektronisches Bauelement mit einer auf einer Aufwachsschicht angeordneten, eine Metallschicht enthaltenden Elektrode.

Bei großflächigen Anwendungen setzen dünne elektrische Kontakte elektronischer Bauelemente, wie beispielsweise optoelektronischer Bauelemente, insbesondere als Deckkontakte, eine gute Bestromung bzw. Leitfähigkeit und gegebenenfalls ausreichende Transparenz voraus.

Die Druckschrift US 2008/0105299 A1 betrifft eine Frontelektrode für eine Photovoltaik-Zelle.

In der Druckschrift JP 2006-337447 A ist eine Flüssigkristallanzeige beschrieben.

Ein transparentes, lichtemittierendes Bauelement findet sich in der Druckschrift EP 1 701 395 A1.

Aus der Druckschrift JP 2003-288993 A ist eine transparente Elektrode für eine organische Leuchtdiode bekannt.

Es offenbart die Druckschrift EP 1 939 954 A2 ein Display, basierend auf einer organischen Licht emittierenden Schichtenfolge, und ein Herstellungsverfahren hierfür.

In der Druckschrift EP 2 012 375 A2 findet sich eine OLED mit einer kohlenstoffhaltigen Aufwachsschicht.

Eine Aufgabe der vorliegenden Erfindung ist, ein elektronisches Bauelement mit einer eine Metallschicht aufweisenden Elektrode mit gegenüber dem Stand der Technik verminderter Dicke und verbesserter Transparenz bereitzustellen.

Die erfindungsgemäße Aufgabe wird durch ein elektronisches Bauelement mit den Merkmalen des unabhängigen Anspruchs 1 gelöst. Unteransprüche geben weitere Ausführungsformen des elektronischen Bauelements an.

Das erfindungsgemäße elektronische Bauelement weist ein Substrat, wenigstens eine auf dem Substrat angeordnete, erste Elektrode und auf der dem Substrat zugewandten Seite der Elektrode eine Aufwachsschicht auf. Die auf der Aufwachsschicht angeordnete Elektrode weist eine Metallschicht mit einer Dicke von kleiner oder gleich 30 nm auf und die Aufwachsschicht besitzt eine Dicke, die kleiner oder gleich 10 nm ist.

Ein "Substrat", wie es hierin verwendet wird, kann zum Beispiel ein Substrat, wie es im Stand der Technik herkömmlich für ein elektronisches Bauelement verwendet wird, umfassen. Das Substrat kann ein transparentes Substrat sein. Es kann jedoch auch ein nicht transparentes Substrat sein. Beispielsweise kann das Substrat Glas, Quarz, Saphir, Kunststofffolien, Metall, Metallfolien, Siliziumwafer oder ein anderes geeignetes Substratmaterial umfassen. Ein Metallsubstrat wird im Regelfall nur dann Verwendung finden, wenn nicht direkt darauf die Aufwachsschicht angeordnet ist. Als Substrat wird erfindungsgemäß insbesondere die Schicht verstanden, auf der bei der Herstellung des elektronischen Bauelements nachfolgend alle anderen Schichten aufgebracht werden. Solche nachfolgenden Schichten können z.B. bei einem optischen elektronischen Bauelement oder einer strahlungsemittierenden Vorrichtung für die Strahlungsemission erforderliche Schichten sein.

Die "erste Elektrode" kann eine Anode oder eine Kathode sein.

Der Begriff "Aufwachsschicht", wie er hierin verwendet wird, bezeichnet eine Schicht, auf welcher eine eine Metallschicht umfassende Elektrode (im Folgenden auch als Aufwachselektrode bezeichnet) angeordnet ist.

Der Beitrag der Aufwachsschicht zur lateralen Stromleitung ist vernachlässigbar.

Die Aufwachsschicht ist erfindungsgemäß aus $Al_2O_3$, $WO_3$, oder $Re_2O_7$ gebildet. Da die Aufwachsschicht eine sehr dünne Schicht ist, muss sie nicht leitfähig sein.

Die Aufwachsschicht kann mittels physikalischer Gasphasenabscheidung, zum Beispiel Verdampfungsverfahren, wie thermischem Verdampfen, Elektronenstrahlverdampfen, Laserstrahlverdampfen, Lichtbogenverdampfen, Molekularstrahlepitaxie und dergleichen, Sputtern, wie ionenstrahlgestützter Deposition und dergleichen, oder Ionenplattieren, chemischer Gasphasenabscheidung, wie plasmaunterstützter chemischer Gasphasenabscheidung und dergleichen, oder Atomlagenabscheidung und dergleichen aufgebracht sein.

Die Oberfläche der Aufwachsschicht ist insbesondere in geeigneter Weise vorbereitet oder ausgelegt, um eine gleichmäßige bzw. homogene Abscheidung einer darauf abzuscheidenden Metallschicht zu ermöglichen. In einer Ausführungsform kann die Oberfläche der Aufwachsschicht eine amorphe oder im Wesentlichen amorphe Struktur bzw. eine amorphe oder im Wesentlichen amorphe Oberfläche aufweisen. Eine vollständig amorphe Struktur kann beispielsweise mittels Röntgenbeugung (XRD-Aufnahmen) bestätigt werden (es werden keine diskreten Bragg-Reflexe erhalten).

Der Begriff "Metallschicht", wie er hierin verwendet wird, bezeichnet eine Schicht, die im Wesentlichen oder vollständig aus Metall gebildet ist. Die Metallschicht ist direkt auf der Aufwachsschicht angeordnet. Sie kann epitaktisch auf der Aufwachsschicht aufgewachsen sein. Die Dicke der Metallschicht beträgt kleiner oder gleich 30 nm, beispielsweise zwischen 9 nm und 10 nm.

Die Metallschicht kann eine Dicke von kleiner oder gleich 15 nm aufweisen, insbesondere von kleiner oder gleich 12 nm.

Bei Ausführungsformen der vorliegenden Erfindung, bei denen es insbesondere auf die Transparenz der Metallschicht ankommt, kann die Dicke der Metallschicht beispielsweise kleiner oder gleich 14 nm, insbesondere kleiner oder gleich 11 nm, betragen. Beispielsweise kann die Dicke einer Metallschicht, welche eine Ag-Schicht oder eine Schicht aus einer Ag-Legierung (z. B. eine Schicht aus einer Ag-Sm-Legierung) aufweist, kleiner oder gleich 14 nm, insbesondere kleiner oder gleich 11 nm, zum Beispiel zwischen etwa 9 nm und etwa 10 nm betragen.

Die Aufwachselektrode kann aus der Metallschicht bestehen oder eine oder weitere Schichten oder Funktionsschichten umfassen.

Die Metallschicht der Aufwachselektrode umfasst bevorzugt mindestens ein Metall, das ausgewählt ist aus der Gruppe, bestehend aus Aluminium, Barium, Indium, Silber, Gold, Magnesium, Calcium und Lithium sowie Kombinationen derselben. Die Metallschicht kann alternativ aus einem der vorstehend genannten Metalle oder einer Verbindung mit einem dieser Metalle oder aus mehreren dieser Metalle, insbesondere einer Legierung, bestehen.

Die Aufwachselektrode kann in transparenten und nichttransparenten elektronischen, optischen oder elektrooptischen Bauteilen eingesetzt werden. Die auf der Aufwachsschicht angeordnete Aufwachselektrode kann als Deckkontakt, Substratkontakt und/oder Zwischenkontakt eingesetzt werden.

Das erfindungsgemäße elektronische Bauelement ist als optoelektronisches Bauteil, nämlich als organische Leuchtdiode ausgeführt.

Der Begriff "Schicht", wie er hierin verwendet wird, kann eine einzelne Schicht oder eine Schichtenfolge aus mehreren dünnen Schichten bezeichnen. Insbesondere können die Funktionsschichten, beispielsweise organische Funktionsschichten, aus mehreren Schichten gebildet sein. Die Metallschicht und die Aufwachsschicht sind meist einschichtig.

Der Begriff "aufeinander angeordnet", wie er hierin verwendet wird, meint, dass eine Schicht unmittelbar in direktem mechanischem und/oder elektrischem Kontakt auf einer anderen Schicht angeordnet ist. Eine Schicht kann auch mittelbar auf einer anderen Schicht angeordnet sein, wobei dann weitere Schichten zwischen den angegebenen Schichten vorhanden sein können. Solche Schichten können dazu dienen, die Funktionalität und damit die Effizienz des elektronischen Bauelements weiter zu verbessern. Die Metallschicht ist im Regelfall direkt auf der Aufwachsschicht angeordnet.

Mit der in dem elektronischen Bauelement erfindungsgemäß vorgesehenen Kombination aus Aufwachsschicht und Metallschicht ist es in vorteilhafter Weise möglich, einen sehr dünnen und zugleich sehr leitfähigen Kontakt bereitzustellen, der - falls erforderlich - zusätzlich auch hochtransparent ausgebildet sein kann.

Durch Abscheiden der Metallschicht auf der dünnen Aufwachsschicht kann die Aufwachselektrode in vorteilhafter Weise gleichmäßig, glatt und im Wesentlichen homogen ausgebildet werden. Sie kann insbesondere aus diesem Grund wesentlich dünner ausgeführt werden als nach dem Stand der Technik. Somit ist es - anders als mit den im Stand der Technik eingesetzten transparenten Kontakten aus entweder transparenten leitenden Oxiden mit einer Leitfähigkeit von größer 15 $\Omega/\square$ oder dünnen Metallschichten mit einer Dicke von mindestens 20 nm - in vorteilhafter Weise möglich, eine hohe Transparenz und gute Bestromung auch bei großflächigen Anwendungen zu erreichen.

Bei den erfindungsgemäßen elektronischen Bauelementen, bei denen eine Transparenz wesentlich ist, kann somit in vorteilhafter Weise ein Kompromiss zwischen Transparenz und Leitfähigkeit transparenter metallischer Kontakte eingegangen werden, da die auf der Aufwachsschicht abgeschiedene Metallschicht in vorteilhafter Weise hinreichend dünn, glatt und geschlossen gebildet sein kann, um so beispielsweise eine ausreichende Leitfähigkeit und gleichzeitig eine hervorragende Transparenz bereitzustellen.

Weitere Ausgestaltungen der strahlungsemittierenden Vorrichtung sind Gegenstand von Unteransprüchen.

In einer Weiterbildung des erfindungsgemäßen elektronischen Bauelements besitzt die Aufwachsschicht insbesondere eine Dicke von 1 nm bis 8 nm. Die Aufwachsschicht besitzt bevorzugt eine Dicke von 3 nm bis 3,5 nm. In bestimmten Ausführungsformen kann eine Dicke von größer oder gleich 1,5 nm vorteilhaft sein. Die Dicke der Aufwachsschicht kann in bestimmten Ausführungsformen beispielsweise kleiner oder gleich 7 nm sein.

In einer nicht erfindungsgemäßen Abwandlung des elektronischen Bauelements ist die Aufwachsschicht ausgewählt aus einer Schicht aus Indium-dotiertem Zinnoxid (ITO) und einer Schicht aus Aluminium-dotiertem Zinkoxid (AZO).

In einer Weiterbildung des erfindungsgemäßen elektronischen Bauelements weist die Metallschicht eine Dickenhomogenität von $\pm$ 10 % häufig sogar $\pm$ 5 %, auf. Der Begriff "Dickenhomogenität", wie er hierin verwendet wird, meint, dass die Metallschicht eine über ihre im Wesentlichen oder vollständige Länge nahezu konstante Dicke, d.h. eine Dicke mit einer maximalen Abweichung von z.B. $\pm$ 10 %, besitzen kann. Dies kann beispielsweise insbesondere durch die unter der Metallschicht angeordnete (dünne) Aufwachsschicht erreicht werden.

Die Maximaldicke einer "30 nm dicken" Metallschicht kann also beispielsweise maximal 33 nm betragen, die maximale Dicke einer "12 nm dicken" Metallschicht beispielsweise maximal 13,2 nm.

In einer weiteren Ausführungsform der vorliegenden Erfindung beträgt der Flächenwiderstand der Aufwachselektrode auf der Aufwachsschicht kleiner oder gleich 6 $\Omega/\square$. Der Flächenwiderstand kann insbesondere kleiner oder gleich 5 $\Omega/\square$ betragen. Beispielsweise kann der Flächenwiderstand zwischen 4 $\Omega/\square$ und 5 $\Omega/\square$ betragen.

Der Begriff "Flächenwiderstand", wie er hierin verwendet wird, bezeichnet den isotropen spezifischen Widerstand einer Schicht bezogen auf die Dicke derselben. Der Flächenwiderstand kann beispielsweise mit Hilfe der Vier-Punkt-Methode gemessen werden. Alternativ kann ein Flächenwiderstand auch mit der speziellen Van-der-Pauw-Methode gemessen werden.

Der Flächenwiderstand kann damit in vorteilhafter Weise geringer sein, als es bislang im Stand der Technik mit vergleichbaren Elektrodenschichten üblich war, die auf einem anderen Substrat als der Aufwachsschicht gemäß der vorliegenden Erfindung abgeschieden wurden. Mit der erfindungsgemäßen Anordnung kann es in vorteilhafter Weise möglich sein, eine gleichmäßige Bestromung der dünnen Aufwachselektrode - in optoelektronischen Bauelementen bei ausreichender Transparenz - zu erreichen.

Es ist das erfindungsgemäße elektronische Bauelement ein organisch elektronisches Bauelement und weist ferner eine zweite Elektrode und wenigstens eine zwischen der ersten Elektrode und der zweiten Elektrode angeordnete organische Funktionsschicht auf.

Das organisch elektronische Bauelement ist eine strahlungsemittierende Vorrichtung.

Die "erste Elektrode" kann eine Anode sein. Sie kann lochinjizierende Funktionen aufweisen.

Die "zweite Elektrode" kann eine Kathode sein. Die erste Elektrode und die zweite Elektrode sind in geeigneter Weise elektrisch kontaktiert.

Die Elektrode, welche auf der Aufwachsschicht angeordnet ist, wird - wie vorher angegeben - auch als Aufwachselektrode bezeichnet. Die Aufwachselektrode kann als Anode oder Kathode vorgesehen sein oder einen Teil einer solchen bilden. Der Klarheit halber wird gemäß der vorliegenden Erfindung stets von Anordnungen gesprochen, die genau eine Aufwachselektrode aufweisen. Allerdings können auch beide Elektroden eine Aufwachsschicht mit direkt darauf angeordneter Metallschicht aufweisen.

Die Elektrode, die nicht auf einer Aufwachsschicht angeordnet ist, kann aus einem Material gebildet sein oder ein Material umfassen, das ausgewählt ist aus Metallen wie Aluminium, Barium, Indium, Silber, Gold, Magnesium, Calcium und Lithium sowie Kombinationen derselben oder einer Verbindung derselben, insbesondere einer Legierung, sowie transparenten leitfähigen Oxiden, wie beispielsweise Metalloxiden, wie Zinkoxid, Zinnoxid, Cadmiumoxid, Titanoxid, Indiumoxid oder Indium-dotiertem Zinnoxid (ITO), Aluminium-dotiertem Zinkoxid (AZO) , $Zn_2SnO_4$, $CdSnO_3$, $ZnSnO_3$, $MgIn_2O_4$, $GaInO_3$, $Zn_2In_2O_5$ oder $In_4Sn_3O_{12}$ oder Mischungen unterschiedlicher transparenter leitender Oxide.

Eine "organische Funktionsschicht" kann Emitterschichten, beispielsweise mit fluoreszierenden und/oder phosphoreszierenden Emittern, enthalten.

Beispiele für Emittermaterialien, die in dem erfindungsgemäßen elektronischen Bauelement bzw. der strahlungsemittierenden Vorrichtung der vorliegenden Erfindung eingesetzt werden können, schließen organische oder organometallische Verbindungen, wie Derivate von Polyfluoren, Polythiophen und Polyphenylen (z.B. 2- oder 2,5-substituiertes Poly-p-phenylenvinylen) sowie Metallkomplexe, beispielsweise Iridium-Komplexe wie blau phosphoreszierendes FIrPic (Bis(3,5-difluoro-2-(2-pyridyl)phenyl-(2-carboxypyridyl)-iridium III), grün phosphoreszierendes $Ir(ppy)_3$ (Tris(2-phenylpyridin)iridium III), rot phosphoreszierendes $Ru$ $(dtb-bpy)_3*2(PF_6)$ (Tris[4,4'-di-tert-butyl-(2,2')-bipyridin]ruthenium(III)komplex) sowie blau fluoreszierendes DPAVBi (4,4-Bis[4-(di-p-tolylamino)styryl]biphenyl), grün fluoreszierendes TTPA (9,10-Bis[N,N-di-(p-tolyl)-amino]anthracen) und rot fluoreszierendes DCM2 (4-Dicyanomethylen)-2-methyl-6-julolidyl-9-enyl-4H-pyran) als nichtpolymere Emitter ein. Solche nichtpolymeren Emitter sind beispielsweise mittels thermischem Verdampfen abscheidbar. Ferner können Polymeremitter eingesetzt werden, welche insbesondere mittels nasschemischen Verfahren, wie beispielsweise Spin Coating, abscheidbar sind.

Die Emittermaterialien können in geeigneter Weise in einem Matrixmaterial eingebettet sein.

Die Emittermaterialien der Emitterschichten des elektronischen Bauelements können insbesondere so ausgewählt sein, dass das elektronische Bauelement Weißlicht emittiert. Die Emitterschicht kann mehrere verschiedenfarbig (zum Beispiel blau und gelb oder blau, grün und rot) emittierende Emittermaterialien umfassen, alternativ kann die Emitterschicht auch aus mehreren Teilschichten aufgebaut sein, wie einer blau fluoreszierenden Emitterschicht, einer grün phosphoreszierenden Emitterschicht und einer rot phosphoreszierenden Emitterschicht. Durch die Mischung der verschiedenen Farben kann die Emission von Licht mir einem weißen Farbeindruck resultieren. Alternativ kann auch vorgesehen sein, im Strahlengang der durch diese Schichten erzeugten Primäremission ein Konvertermaterial anzuordnen, das die Primärstrahlung zumindest teilweise absorbiert und eine Sekundärstrahlung anderer Wellenlänge emittiert, so dass sich aus einer (noch nicht weißen) Primärstrahlung durch die Kombination von primärer und sekundärer Strahlung ein weißer Farbeindruck ergibt.

Das elektronische Bauelement kann allgemein weitere organische Funktionsschichten umfassen, die dazu dienen, die Funktionalität und damit die Effizienz des elektronischen Bauelements weiter zu verbessern.

Beispielsweise können organische Funktionsschichten ausgewählt sein, die dazu dienen, die Funktionalität und die Effizienz der ersten Elektrode und/oder der zweiten Elektrode sowie des Ladungsträger- und Exzitonentransports zu verbessern.

Das elektronische Bauelement kann als "Bottom-Emitter" und/oder "Top-Emitter" ausgeführt sein.

Erfindungsgemäß ist die Aufwachsschicht zwischen der organischen Funktionsschicht und Aufwachselektrode angeordnet. Die Aufwachselektrode kann dabei eine Kathode sein.

Die Anordnung der Aufwachsschicht und der Aufwachselektrode kann einen transparenten Deckkontakt für einen Top-Emitter bilden.

Zusätzlich kann eine Aufwachsschicht zwischen dem Substrat und der substratseitigen Elektrode (also der Elektrode, die einen geringeren Abstand zum Substrat aufweist) als Aufwachselektrode angeordnet sein. Diese Aufwachselektrode kann dabei eine Anode sein. Das Substrat kann bevorzugt ein transparentes Substrat wie Glas, Quarz, Saphir, Kunststofffolie und dergleichen sein.

Die Anordnung der Aufwachsschicht und der Aufwachselektrode kann einen transparenten Substratkontakt für einen Bottom-Emitter bilden.

Ganz allgemein gilt, dass bei einem Top- oder Bottom-Emitter eine Elektrode der strahlungsemittierenden Vorrichtung in Form der Aufwachselektrode gemäß der vorliegenden Erfindung transparent und die andere Elektrode reflektierend ausgeführt sein kann. Alternativ dazu können auch beide Elektroden transparent ausgeführt sein.

Die Metallschicht der Aufwachselektrode bildet daher insbesondere einen transparenten Dünnfilmkontakt.

Der Begriff "Bottom-Emitter", wie er hierin verwendet wird, bezeichnet eine Ausführung, die zu der Substratseite des elektronischen Bauelements hin transparent ausgeführt ist. Insbesondere können dazu wenigstens das Substrat, die erste Elektrode und die zwischen dem Substrat und der ersten Elektrode angeordnete Aufwachsschicht transparent ausgeführt sein. Ein als Bottom-Emitter ausgeführtes elektronisches Bauelement kann demnach beispielsweise in den organischen Funktionsschichten erzeugte Strahlung auf der Substratseite des elektronischen Bauelements emittieren.

Alternativ oder zusätzlich dazu kann das erfindungsgemäße elektronische Bauelement als "Top-Emitter" ausgeführt sein. Der Begriff "Top-Emitter", wie er hierin verwendet wird, bezeichnet eine Ausführung, die zu der Seite der zweiten Elektrode des elektronischen Bauelements hin transparent ausgeführt ist. Insbesondere können dazu die Aufwachsschicht und die Aufwachselektrode substratfern angeordnet sein und transparent ausgeführt sein. Ein als Top-Emitter ausgeführtes elektronisches Bauelement kann demnach beispielsweise in den organischen Funktionsschichten erzeugte Strahlung auf der Seite der substratfernen Elektrode des elektronischen Bauelements emittieren.

Ein als Top-Emitter ausgestaltetes elektronisches Bauelement der vorliegenden Erfindung, bei welchem die Aufwachsschicht und die Metallschicht als Deckkontakt vorgesehen sind, kann in vorteilhafter Weise eine hohe Lichtauskopplung und eine sehr geringe Winkelabhängigkeit der Strahlungsdichte aufweisen. Die erfindungsgemäße strahlungsemittierende Vorrichtung kann in vorteilhafter Weise für Beleuchtungen, wie beispielsweise Raumleuchten, eingesetzt werden.

Eine Kombination aus Bottom- und Top-Emitter ist in gleicher Weise möglich. Bei einer solchen Ausführung ist das elektronische Bauelement allgemein in der Lage, das in den organischen Funktionsschichten erzeugte Licht in beide Richtungen - also sowohl zu der Substratseite als auch zu der substratfernen Seite hin - zu emittieren.

In einer weiteren Ausführungsform der vorliegenden Erfindung ist zwischen der ersten Elektrode und der zweiten Elektrode wenigstens eine dritte Elektrode angeordnet.

Die "dritte Elektrode" kann als Zwischenkontakt fungieren. Sie kann dazu dienen, einen Ladungstransport durch die Schichten des elektronischen Bauelements hindurch zu erhöhen und damit die Effizienz des elektronischen Bauelements in vorteilhafter Weise zu verbessern. Die dritte Elektrode kann als ambipolare Schicht ausgestaltet sein; sie kann als Kathode oder Anode ausgestaltet sein. Die Anordnung der Aufwachsschicht und der Aufwachselektrode der vorliegenden Ausführungsform bildet dann einen transparenten Zwischenkontakt. Ebenso wie die erste und die zweite Elektrode ist die dritte Elektrode elektrisch kontaktiert.

In einer Weiterbildung des elektronischen Bauelements der vorliegenden Erfindung sind als organische Funktionsschichten eine Emitterschicht und eine oder mehrere weitere organische Funktionsschichten enthalten. Die weiteren organischen Funktionsschichten können ausgewählt sein aus der Gruppe, bestehend aus Lochinjektionsschichten, Lochtransportschichten, lochblockierenden Schichten, Elektroneninjektionsschichten, Elektronentransportschichten und elektronenblockierenden Schichten.

Geeignete Funktionsschichten und geeignete organische Funktionsschichten sind dem Fachmann bekannt. Die (organischen) Funktionsschichten können vorzugsweise mittels thermischem Verdampfen aufgebracht werden. Die weiteren (organischen) Funktionsschichten können die Funktionalität und/oder Effizienz des elektronischen Bauelements in vorteilhafter Weise verbessern.

In einer weiteren Ausführungsform der vorliegenden Erfindung ist das elektronische Bauelement als organische Leuchtdiode (OLED) ausgebildet.

In einer Weiterbildung des elektronischen Bauelements weist das elektronische Bauelement eine im Wesentlichen Lambertsche Abstrahlcharakteristik auf.

Der Begriff "Lambertsche Abstrahlcharakteristik", wie er hierin verwendet wird, bezeichnet das ideale Abstrahlverhalten eines so genannten Lambert-Strahlers.

Eine "im Wesentlichen" Lambertsche Abstrahlcharakteristik, wie sie hierin bezeichnet ist, meint dabei insbesondere, dass die Abstrahlcharakteristik, welche sich nach der Formel

$$I(\Theta) = I_0 \cdot \cos\Theta$$

berechnet und in der $I_0$ die Intensität bezogen auf eine Flächennormale ist und $\Theta$ den Winkel zur Flächennormalen angibt, für einen gegebenen Winkel, insbesondere bei einem Winkel zwischen -70° und +70°, für jeden gegebenen Winkel $\Theta$ um nicht mehr als 10 % von der Intensität gemäß der oben genannten Formel abweicht, also $I(\Theta) = I_0 \cdot \cos\Theta \cdot x$, wobei x = 90 % - 110 %.

Auf diese Weise kann es vorteilhaft möglich sein, eine nach allen Richtungen konstante Strahldichte bzw. Leuchtdichte des elektronischen Bauelements der vorliegenden Erfindung zu erreichen, so dass das elektronische Bauelement in allen Richtungen gleich hell scheint. Die Helligkeit des elektronischen Bauelements kann sich in vorteilhafter Weise auch dann nicht ändern, wenn es gegenüber der Blickrichtung verkippt wird.

In einer weiteren Ausführungsform beträgt die Transparenz des elektronischen Bauelements größer oder gleich 60 %.

Vorzugsweise kann die Transparenz größer oder gleich 65 % betragen. Die Transparenz wird mittels Intensitätsmessungen gemessen, indem vorgegebene Wellenlängenbereich abgetastet und die durch die strahlungsemittierende Vorrichtung tretende Lichtmenge erfasst wird.

Der Begriff "Transparenz", wie er hierin verwendet wird, bezeichnet die Fähigkeit der einzelnen Schichten des erfindungsgemäßen elektronischen Bauelements, elektromagnetische Wellen - und insbesondere sichtbares Licht - durchzulassen. Die Transparenz des elektronischen Bauelements gemäß der vorliegenden Erfindung beträgt im Regelfall zumindest für wenigstens eine konkrete Wellenlänge mehr als 60 %, vorzugsweise mehr als 65 %. Insbesondere kann die Transparenz für wenigstens eine Wellenlänge in einem Wellenlängenbereich von etwa 400 nm bis etwa 450 nm mehr als 60 % und vorzugsweise mehr als 65 % betragen.

Die erfindungsgemäße Anordnung der Aufwachsschicht und der Aufwachselektrode kann somit in vorteilhafter Weise eine gegenüber dem Stand der Technik verbesserte Transparenz bei gleichzeitig ausreichender Bestromung bereitstellen.

In einer weiteren Ausführungsform der vorliegenden Erfindung ist die Aufwachsschicht mittels Sputtern aufgebracht. Die Aufwachsschicht kann insbesondere mittels Facing Target Sputtern oder Hohlkathoden-Sputtern aufgebracht sein.

Der Begriff "Facing Target Sputtern", wie er hierin verwendet wird, bezeichnet einen einstufigen Prozess, mittels dem geschlossene epitaktische Schichten erhalten werden können.

Der Begriff "Hohlkathoden-Sputtern", wie er hierin verwendet wird, bezeichnet ein Sputterverfahren unter Verwenden einer Hohlkathoden-Sputteranlage, welche eine Hohlkathode aus Targetmaterial aufweist. Im Vergleich zu den üblicherweise bei einem Druck von < 1 Pa ablaufenden Sputterverfahren, können beim Hohlkathoden-Sputtern verbesserte Eigenschaften der Aufwachsschicht erhalten werden, da in vorteilhafter Weise praktisch kein Bombardement der Schicht mit energetischen, vom Target reflektierten Neutralteilchen stattfindet.

Die mittels Facing Target Sputtern oder Hohlkathoden-Sputtern abgeschiedene Aufwachsschicht weist im Regelfall ein im Wesentlichen amorphes Erscheinungsbild bzw. eine im Wesentlichen amorphe Oberfläche auf. Auf einer solchen amorphen Oberfläche kann besonders gut eine dünne Metallschicht abgeschieden werden, um auf diese Weise in vorteilhafter Weise einen transparenten Kontakt für ein elektronisches Bauelement der vorliegenden Erfindung bereitzustellen. Mittels Sputtern aufgebrachte Schichten weisen im Regelfall Einschlüsse auf, in denen das zum Sputtern verwendete Prozessgas enthalten ist (z.B. Argon).

Durch Verwenden eines Sputterverfahrens zum Aufbringen der Aufwachsschicht kann in vorteilhafter Weise ein Abscheiden nichtstöchiometrischer Schichten, die aus einem thermischen Verdampfen bei zu hohen Temperaturen resultieren können, vermieden werden, wobei die bei reaktivem Sputtern häufig mit zunehmender Beschichtungszeit auftretenden Schädigungen der unterliegenden Schichten durch verschiedene Einflüsse aus dem Sputterplasma aufgrund der erfindungsgemäß vorgesehenen sehr dünnen Aufwachsschicht vermieden werden können.

Durch Aufbringen der Aufwachsschicht mittels Sputtern kann somit in vorteilhafter Weise ein schädigungsfreies und/oder stöchiometrisches Aufbringen der Aufwachsschicht erreicht werden. Dies kann insbesondere beispielsweise bei der Beschichtung empfindlicher Strukturen, wie sie zum Beispiel bei organischen Leuchtdioden vorhanden sind, von Vorteil sein.

In einer weiteren Ausführungsform der vorliegenden Erfindung ist die Metallschicht zeitlich unmittelbar nach der Aufwachsschicht aufgebracht.

Der Begriff "zeitlich unmittelbar aufgebracht" oder bevorzugt "hintereinander aufgebracht", wie er hierin verwendet wird, meint, dass die Metallschicht während des Herstellungsprozesses des elektronischen Bauelements zeitlich direkt nach der Aufwachsschicht abgeschieden wird, z.B. ohne Reaktorwechsel oder nicht später als einen Tag nach Abscheiden der Aufwachsschicht.

Durch die unmittelbare Abscheidung der Metallschicht auf der Aufwachsschicht kann einem Altern der Aufwachsschicht vorgebeugt werden, insbesondere tritt keine oder eine nur geringe Alterung der z.B. amorphen Oberfläche ein, wodurch ihr amorphes Erscheinungsbild zum geeigneten Abscheiden der Metallschicht beibehalten werden kann.

Das elektronische Bauelement gemäß der vorliegenden Erfindung umfasst zumindest eine weitere Funktionsschicht, gewählt aus der Gruppe von Antireflektionsschichten, Streuschichten, Schichten zur Farbkonversion von Licht und/oder mechanische Schutzschichten. Derartige Schichten werden auf der Metallschicht der Aufwachselektrode angeordnet.

Die Funktionsschichten können vorzugsweise mittels thermischem Verdampfen abgeschieden werden. Diese Schichten können die Funktion und Effizienz der strahlungsemittierenden Vorrichtung weiter verbessern.

Ein elektrischer Kontakt ist zur Verwendung in bzw. mit einem elektronischen Bauelement geeignet.

Der elektrische Kontakt weist ein Substrat, wenigstens eine auf dem Substrat angeordnete, erste Elektrode und auf der dem Substrat zugewandten Seite der Elektrode eine Aufwachsschicht auf, wobei die auf der Aufwachsschicht angeordnete Elektrode eine Metallschicht mit einer Dicke von kleiner oder gleich 30 nm aufweist und die Aufwachsschicht eine Dicke besitzt, die kleiner oder gleich 10 nm ist, wobei die Aufwachsschicht insbesondere direkt auf dem Substrat angeordnet ist.

Da bereits mit dem elektrischen Kontakt im Wesentlichen alle Vorteile erzielbar sind, welche mit dem erfindungsgemäßen elektronischen Bauteil erzielt werden können, wird bezüglich weiterer Ausgestaltungen zur Vermeidung von Wiederholungen auf die vorstehenden Ausführungen hierzu verwiesen.

Die vorliegende Erfindung wird im Folgenden anhand von Ausführungsformen unter Bezugnahme auf die beigefügten Figuren beschrieben. In den Figuren bezeichnen gleiche Bezugzeichen gleiche oder identische Elemente. Es zeigt:

Fig. 1    eine schematisch vereinfachte Seitenansicht eines elektronischen Bauelements gemäß einer Ausführungsform der vorliegenden Erfindung in einem Teilschnitt;

Fig. 2    eine schematisch vereinfachte Seitenansicht eines elektronischen Bauelements gemäß einer nicht erfindungsgemäßer Abwandlung in einem Teilschnitt;

Fig. 3    eine schematisch vereinfachte Seitenansicht eines elektronischen Bauelements gemäß einer Ausführungsform der vorliegenden Erfindung in einem Teilschnitt;

Fig. 4    eine REM-Aufnahme einer dünnen Silberschicht, die auf einem Glassubstrat abgeschieden ist;

Fig. 5    eine REM-Aufnahme einer dünnen Silberschicht, die auf einem herkömmlichen Organikuntergrund abgeschieden ist;

Fig. 6    eine REM-Aufnahme einer dünnen Silberschicht, die auf einer ITO-Aufwachsschicht abgeschieden ist;

Fig. 7    einen Graphen, der das Ergebnis einer Transparenzmessung der Silberschichten aus den Fig. 3 bis 5 zeigt; und

Fig. 8    Abstrahlcharakteristiken eines elektrooptischen Bauelements zeigt.

In den nachfolgenden Ausführungsformen, die anhand der Zeichnung beispielhaft beschrieben sind, ist das erfindungsgemäße elektronische Bauelement als strahlungsemittierende Vorrichtung, insbesondere als OLED, veranschaulicht.

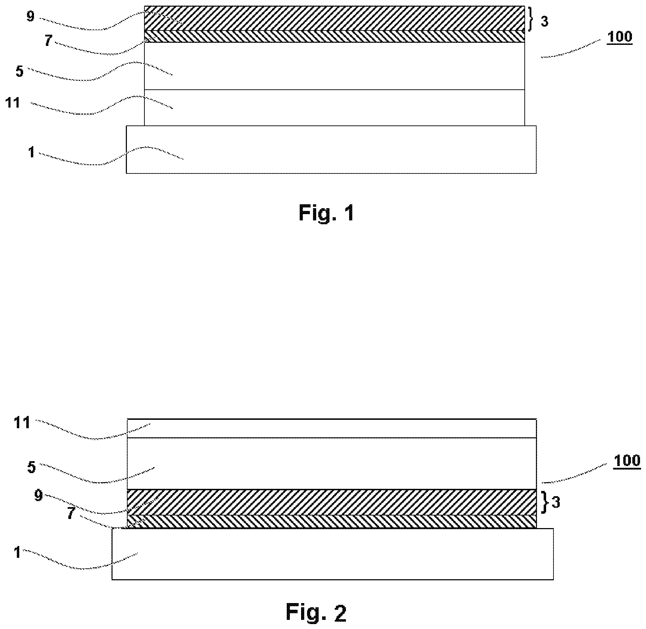

Fig. 1 zeigt eine schematisch vereinfachte Seitenansicht eines elektronischen Bauelements 100 gemäß einer ersten Ausführungsform der vorliegenden Erfindung, die als Top-/Bottom-Emitter ausgestaltet ist.

Auf einem Substrat 1, z.B. einem Glassubstrat, ist eine zweite Elektrode 11 angeordnet. Die zweite Elektrode 11 kann z.B. eine Anode sein und beispielsweise aus Indium-dotiertem Zinnoxid (ITO) gebildet sein.

Auf der zweiten Elektrode 11 ist eine organische Funktionsschicht 5, wie beispielsweise eine fluoreszierende und/oder phosphoreszierende Emitterschicht, angeordnet.

Auf der organischen Funktionsschicht 5 ist eine Aufwachsschicht 7 angeordnet. Die Aufwachsschicht 7 kann z.B. 3 nm dick sein und mittels Facing Target Sputtern abgeschieden sein.

Auf der Aufwachsschicht 7 ist als erste Elektrode 3 eine Aufwachselektrode, z.B. in Form einer 10 nm dicken Metallschicht 9, abgeschieden. Die Metallschicht 9 kann beispielsweise mittels Sputtern abgeschieden sein.

Die die Metallschicht 9 umfassende erste Elektrode 3 ist, wenn die zweite Elektrode 11 eine Anode ist, eine Kathode. Die Aufwachsschicht 7 ist dabei erfindungsgemäß auf der dem Substrat 1 zugewandten Seite der ersten Elektrode 3 angeordnet.

Fig. 2 zeigt eine schematisch vereinfachte Seitenansicht einer nicht erfindungsgemäßer Abwandlung eines elektronischen Bauelements 100, das als Bottom-Emitter ausgestaltet ist.

Auf dem Substrat 1, wie einem Glassubstrat, ist eine Aufwachsschicht 7 und auf der Aufwachsschicht 7 eine Aufwachselektrode in Form einer Metallschicht 9 als erste Elektrode 3 angeordnet sind. Die erste Elektrode 3 kann als Anode ausgestaltet sein. Die Aufwachsschicht 7 ist auf der dem Substrat 1 zugewandten Seite der ersten Elektrode 3 angeordnet.

Die Aufwachsschicht 7 kann in vorteilhafter Weise dazu dienen, die Oberfläche auf der eine Aufwachselektrode aufgebracht worden ist, zu verbessern, d.h. in einer solchen Weise zu behandeln, dass die Metallschicht 9 dünn, glatt und homogen abgeschieden werden kann, um eine verbesserte Bestromung und eine verbesserte Transparenz des elektronischen Bauelements 100 zu ermöglichen.

Auf der Metallschicht 9 ist eine organische Funktionsschicht 5 angeordnet. Die organische Funktionsschicht 5 kann eine Emitterschicht umfassen.

Auf der organischen Funktionsschicht 5 ist die zweite Elektrode 11 angeordnet. Die zweite Elektrode 11 ist, wenn die erste Elektrode 3 eine Anode ist, eine Kathode. Sie kann zum Beispiel eine herkömmliche 20 nm dicke Silberschicht sein.

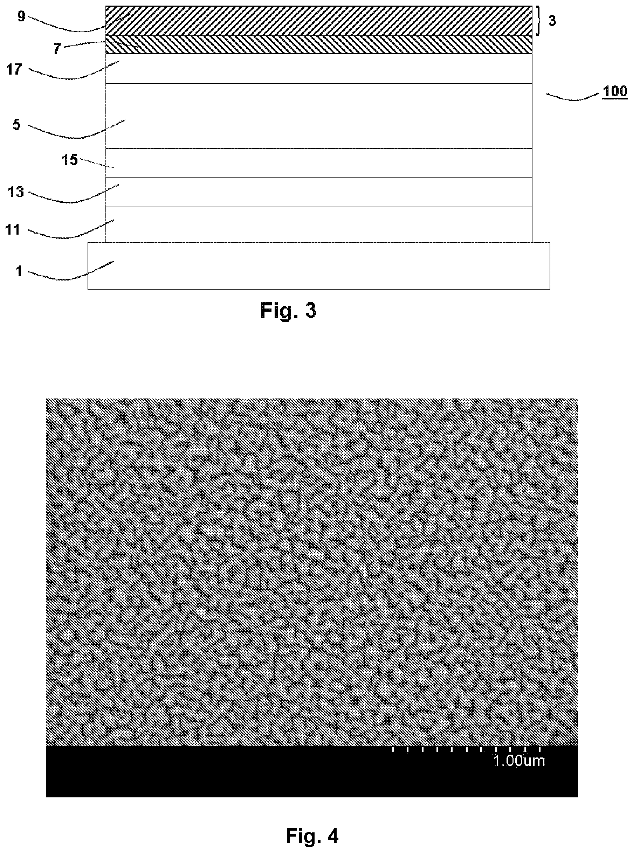

Fig. 3 zeigt eine schematisch vereinfachte Seitenansicht eines elektronischen Bauelements 100 gemäß einer weiteren Ausführungsform der vorliegenden Erfindung, die als Top-Emitter ausgestaltet ist.

Auf einem Substrat 1 ist eine zweite Elektrode 11 angeordnet. Die zweite Elektrode 11 kann, wie in Fig. 3 gezeigt, eine Anode sein und beispielsweise aus Indium-dotiertem Zinnoxid (ITO) gebildet sein.

Auf der zweiten Elektrode 11 ist eine Lochinjektionsschicht 13 und auf dieser eine Lochtransportschicht 15 angeordnet. Die Lochinjektionsschicht 13 und die Lochtrabsportschicht 15 können mittels thermischem Verdampfen abgeschieden sein.

Auf der Lochtransportschicht 15 ist eine weitere organische Funktionsschicht 5, wie beispielsweise eine fluoreszierende und/oder phosphoreszierende Emitterschicht, angeordnet.

Auf der organischen Funktionsschicht 5 ist eine Elektronentransportschicht 17 angeordnet, welche ebenfalls mittels thermischem Verdampfen abgeschieden sein kann. Auf der Elektronentransportschicht 17 ist eine Aufwachsschicht 7 angeordnet. Die Aufwachsschicht 7 kann z.B. 3 nm dick sein und mittels Facing Target Sputtern abgeschieden sein.

Auf der Aufwachsschicht 7 ist als erste Elektrode 3 eine Aufwachselektrode, z.B. in Form einer 10 nm dicken Metallschicht 9, abgeschieden. Die Metallschicht 9 kann bevorzugt mittels Sputtern abgeschieden sein. Die die Metallschicht 9 umfassende erste Elektrode 3 ist, wie in Fig. 3 gezeigt, eine Kathode.

Fig. 4 zeigt eine REM-Aufnahme einer dünnen Silberschicht, die auf einem Glassubstrat abgeschieden ist. Die Silberschicht ist 12 nm dick und wurde mittels thermischem Verdampfen auf das Glassubstrat aufgebracht. Wie in Fig. 4 zu sehen ist, neigt die Silberschicht stark zur Inselbildung; zwischen den Metallinseln ist das Glassubstrat zu erkennen. Die Silberschicht ist daher nicht glatt und homogen auf dem Glassubstrat ausgebildet. Der mit einem Vier-Spitzen-Messgerät gemessene Flächenwiderstand dieser Silberschicht beträgt 19,3 $\Omega/\square$ ± 1, 9 $\Omega/\square$.

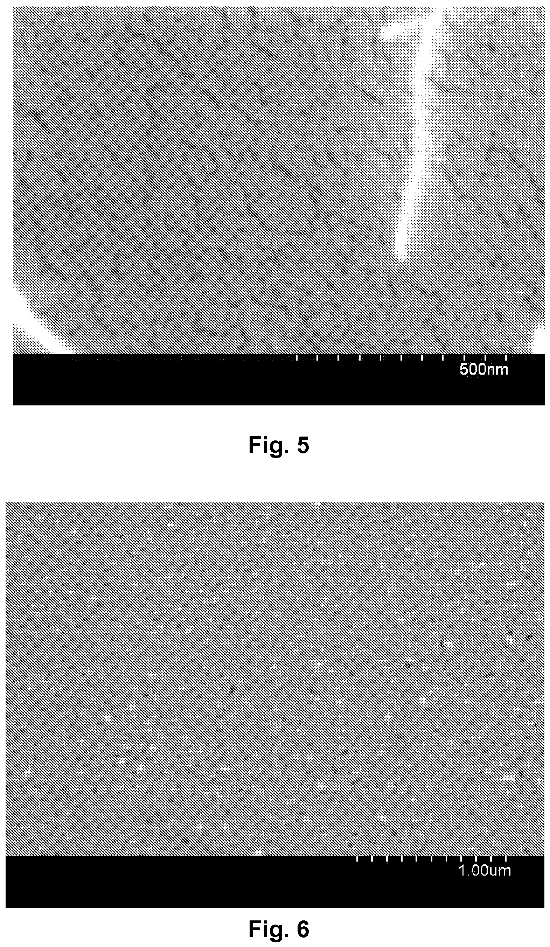

Fig. 5 zeigt eine REM-Aufnahme einer 12 nm Silberschicht, die mittels thermischem Verdampfen auf einem Organikuntergrund abgeschieden ist. Der Organikuntergrund ist auf einem Glassubstrat abgeschieden und besteht aus einem herkömmlichen Matrixmaterial, wie beispielsweise $\alpha$-NPD (N,N'-diphenyl-N,N'-bis(1-naphthyl)-1,1'biphenyl-4,4"diamin. Die Inselbildungstendenz der Silberschicht ist wesentlich geringer als in Fig. 4; es sind jedoch deutliche Risse zu erkennen. Der mit einem Vier-Spitzen-Messgerät gemessene Flächenwiderstand dieser Silberschicht beträgt 7,13 $\Omega/\square$ ± 0,37 $\Omega/\square$.

Fig. 6 zeigt eine REM-Aufnahme einer 12 nm dicken Silberschicht, die mittels Sputtern auf einer 17 nm dicken nicht erfindungsgemäßen ITO-Aufwachsschicht abgeschieden wurde. Diese ITO-Aufwachsschicht wiederum wurde auf einem 90 nm dicken Organikuntergrund, wie er beispielsweise vorstehend in Bezug auf Fig. 5 angegeben ist, aufgebracht. Der Organikuntergrund wurde auf ein Glassubstrat aufgebracht. Die Silberschicht ist, wie in Fig. 6 zu sehen ist, glatt und geschlossen ausgebildet. Der mit einem Vier-Spitzen-Messgerät gemessene Flächenwiderstand dieser Silberschicht beträgt 4,48 $\Omega/\square$ ± 0,20 $\Omega/\square$.

Die dünne amorphe Aufwachsschicht gemäß der vorliegenden Erfindung ermöglicht in vorteilhafter Weise, dass die Metallschicht - im Vergleich zu herkömmlichen Metallschichten bzw. Elektrodenschichten mit einer Dicke von z.B. 20 nm - dünn, glatt und als geschlossene Schicht auf der Aufwachschicht abscheidbar ist.

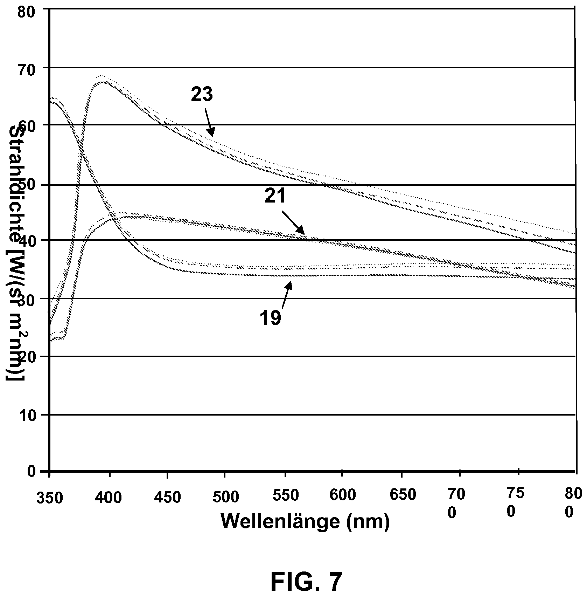

Fig. 7 zeigt einen Graphen, der das Ergebnis einer Transparenzmessung der Silberschichten (Silberschicht auf Glassubstrat gemäß Fig. 4, Silberschicht auf Organikuntergrund auf Glassubstrat gemäß Fig. 5 und Silberschicht auf ITO-Schicht auf Organikuntergrund auf Glassubstrat gemäß Fig. 5) aus den Fig. 4 bis 6 zeigt. Pro Beispiel wurden drei Messungen durchgeführt. Es ist die Transparenz [%] bezogen auf die Wellenlänge [nm] angegeben.

Die Silberschicht auf Glasuntergrund 19 aus Fig. 4 zeigt eine Strahldichte von etwa 65 % bei einer Wellenlänge von etwa 355 nm, das ab ca. 410 nm auf einen minimalen Wert von etwa 35 % abfällt und bei höheren Wellenlängen konstant bleibt.

Die Silberschicht auf Organikuntergrund 21 aus Fig. 5 zeigt ein Transparenzmaximum von etwa 43 % bei etwa 400 nm. Die Transparenz fällt bei höheren Wellenlängen langsam auf einen Wert von etwa 32 % ab.

Die Silberschicht auf Indium-dotiertem Zinnoxid (ITO) 23 aus Fig. 6 zeigt bei etwa 400 nm ein Transparenzmaximum von etwa 68 %. Im Bereich von etwa 380 nm bis etwa 450 nm ist die Transparenz größer als 60 %. Die Transparenz der Silberschicht auf Indium-dotiertem Zinnoxid 23 ist deutlich größer als die der anderen Schichten 19 und 21.

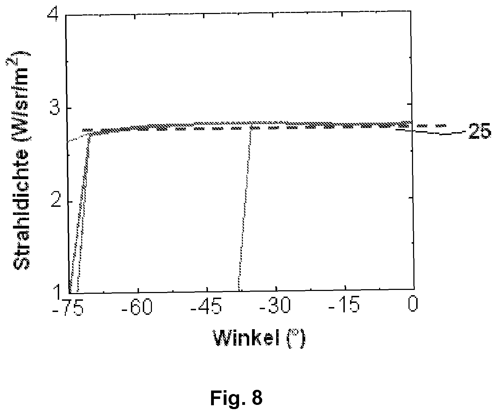

Fig. 8 zeigt die Abstrahlcharakteristiken eines optoelektronischen Bauelements. Es wurden drei Messungen durchgeführt. Die Abstrahlcharakteristiken sind als Strahldichte (angegeben in $[W/(sr/m^2)]$) bezogen auf den Betrachtungswinkel (angegeben in Grad [°]) dargestellt. Die Einheit "sr" bezeichnet den Steradianten, d.h. den Raumwinkel.

Die Abstrahlcharakteristik 25 der in Fig. 5 beschriebenen Anordnung eines elektronischen Bauelements, die beispielsweise als eine top-emittierende OLED ausgebildet ist, zeigt eine im Wesentlichen Lambertsche Abstrahlcharakteristik. Die Lambertsche Abstrahlcharakteristik ist als gestrichelte Linie eingezeichnet und trägt kein Bezugszeichen.

**Patentansprüche**

1.  Elektronisches Bauelement, aufweisend:

    - ein Substrat (1),
    - wenigstens eine auf dem Substrat (1) angeordnete erste Elektrode (3),
    - auf der dem Substrat (1) zugewandten Seite der Elektrode (3) eine Aufwachsschicht (7), wobei
    - die auf der Aufwachsschicht (7) angeordnete Elektrode (3) eine Metallschicht (9) mit einer Dicke von kleiner oder gleich 30 nm aufweist und die Aufwachsschicht (7) eine Dicke besitzt, die kleiner oder gleich 10 nm ist,

- das elektronische Bauelement als organische Leuchtdiode ausgebildet ist und ferner eine zweite Elektrode (11) und wenigstens eine zwischen der ersten Elektrode (3) und der zweiten Elektrode (11) angeordnete organische Funktionsschicht (5, 13, 15, 17) aufweist, und

- die Aufwachsschicht (7) in Richtung weg von dem Substrat (1) unmittelbar auf die organische Funktionsschicht (5, 13, 15, 17) folgt und die erste Elektrode (3) unmittelbar auf die Aufwachsschicht (7) folgt und unmittelbar auf die erste Elektrode (3) eine Funktionsschicht, die eine Antireflexionsschicht, eine Streuschicht, eine Schicht zur Farbkonversion von Licht und/oder eine mechanische Schutzschicht ist, folgt, **dadurch gekennzeichnet, dass** die Aufwachsschicht (7) aus $Al_2O_3$, $WO_3$ oder $Re_2O_7$ gebildet ist.

2. Elektronisches Bauelement nach Anspruch 1, wobei die Aufwachsschicht (7) eine Dicke von 1 nm bis 8 nm besitzt.

3. Elektronisches Bauelement nach einem der vorangegangenen Ansprüche, wobei die Metallschicht (9) eine Dickenhomogenität von $\pm$ 10 % aufweist.

4. Elektronisches Bauelement nach einem der vorangegangenen Ansprüche, wobei die Metallschicht (9) mindestens ein Metall umfasst, das ausgewählt ist aus der Gruppe, bestehend aus Aluminium, Barium, Indium, Silber, Gold, Magnesium, Calcium und Lithium sowie Kombinationen derselben oder aus diesem Metall oder einer Verbindung aus diesem Metall oder aus mehreren dieser Metalle besteht.

5. Elektronisches Bauelement nach einem der vorangegangenen Ansprüche, wobei der Flächenwiderstand des elektronischen Bauelements (100) kleiner oder gleich 8 $\Omega/\square$ ist.

6. Elektronisches Bauelement nach einem der vorangegangenen Ansprüche, wobei die erste Elektrode (3) aus der Metallschicht (9) besteht.

7. Elektronisches Bauelement nach einem der vorangegangenen Ansprüche, das eine Lambertsche Abstrahlcharakteristik (19) aufweist.

8. Elektronisches Bauelement nach einem der vorangegangenen Ansprüche, mit einer Transparenz größer oder gleich 60 %.

9. Elektronisches Bauelement nach einem der vorangegangenen Ansprüche, wobei die Aufwachsschicht (7) mittels Sputtern aufgebracht ist.

10. Elektronisches Bauelement nach einem der vorangegangenen Ansprüche, wobei die Aufwachsschicht (7) eine amorphe Struktur aufweist.

**Claims**

1. Electronic component, comprising:

- a substrate (1),
- at least one first electrode (3) arranged on the substrate (1),
- a growth layer (7) on the side of the electrode (3) facing the substrate (1),
wherein
- the electrode (3) arranged on the growth layer (7) has a metal layer (9) with a thickness of less than or equal to 30 nm and the growth layer (7) has a thickness which is less than or equal to 10 nm,
- the electronic component is formed as an organic light-emitting diode and further has a second electrode (11) and at least one organic functional layer (5, 13, 15, 17) arranged between the first electrode (3) and the second electrode (11), and
- the growth layer (7) directly follows the organic functional layer (5, 13, 15, 17) in direction away from the substrate (1) and the first electrode (3) directly follows the growth layer (7) and a functional layer, which is an anti-reflection layer, a scatter layer, a layer for colour conversion of light and/or a mechanical protective layer, directly follows the first electrode (3),
**characterized in that**
the growth layer (7) is formed from $Al_2O_3$, $WO_3$ or $Re_2O_7$.

2. Electronic component according to claim 1, wherein the growth layer (7) has a thickness of 1 nm to 8 nm.

3. Electronic component according to one of the preceding claims, wherein the metal layer (9) has a thickness homogeneity of $\pm$ 10%.

4. Electronic component according to one of the preceding claims, wherein the metal layer (9) comprises at least one metal selected from the group consisting of aluminum, barium, indium, silver, gold, magnesium, calcium and lithium and combinations thereof or of the metal or a compound of the metal or a plurality of the metals.

5. Electronic component according to one of the preceding claims, wherein the surface resistivity of the electronic component (100) is less than or equal to 8$\Omega/\square$.

6. Electronic component according to one of the preceding claims, wherein the first electrode (3) consists of the metal layer (9).

7. Electronic component according to one of the preceding claims, which has a Lambertian radiation characteristic (19).

8. Electronic component according to one of the preceding claims, with a transparency greater than or equal to 60 %.

9. Electronic component according to one of the preceding claims, wherein the growth layer (7) is applied by means of sputtering.

10. Electronic component according to one of the preceding claims, wherein the growth layer (7) has an amorphous structure.

**Revendications**

1. Composant électronique, comprenant:

   - un substrat (1),
   - au moins une première électrode (3) disposée sur le substrat (1),
   - une couche de croissance (7) sur le côté de l'électrode (3) tourné vers le substrat (1), dans laquelle
   - l'électrode (3) disposée sur la couche de croissance (7) présente une couche métallique (9) d'une épaisseur inférieure ou égale à 30 nm et la couche de croissance (7) présente une épaisseur inférieure ou égale à 10 nm,
   - le composant électronique est formé sous la forme d'une diode électroluminescente organique et présente en outre une deuxième électrode (11) et au moins une couche fonctionnelle organique (5, 13, 15, 17) disposée entre la première électrode (3) et la deuxième électrode (11), et
   - la couche de croissance (7) suit directement la couche fonctionnelle organique (5, 13, 15, 17) en direction opposée au substrat (1) et la première électrode (3) suit directement la couche de croissance (7) et une couche fonctionnelle, qui est une couche antireflet, une couche de diffusion, une couche pour convertir la couleur de lumière et/ou une couche de protection mécanique, suit directement la première électrode (3),
   **caractérisé en ce que**
   la couche de croissance (7) est formée de Al$_2$O$_3$, WO$_3$ ou Re$_2$O$_7$.

2. Composant électronique selon la revendication 1, dans lequel la couche de croissance (7) a une épaisseur de 1 nm à 8 nm.

3. Composant électronique selon l'une des revendications précédentes, dans lequel la couche métallique (9) présente une homogénéité d'épaisseur de 10%.

4. Composant électronique selon l'une des revendications précédentes, dans lequel la couche métallique (9) comprend au moins un métal choisi dans le groupe constitué par l'aluminium, le baryum, l'indium, l'argent, l'or, le magnésium, le calcium et le lithium et leurs combinaisons ou par le métal ou un composé dudit métal ou plusieurs desdits métaux.

5. Composant électronique selon l'une des revendications précédentes, dans lequel la résistivité de surface du composant électronique (100) est inférieure ou égale à 8 Ω/□.

6. Composant électronique selon l'une des revendications précédentes, dans lequel la première électrode (3) étant constituée de la couche métallique (9).

7. Composant électronique selon l'une des revendications précédentes, qui présente une caractéristique de rayonnement lambertien (19).

8. Composant électronique selon l'une des revendications précédentes, avec une transparence supérieure ou égale à 60 %.

9. Composant électronique selon l'une des revendications précédentes, dans lequel la couche de croissance (7) est appliquée par pulvérisation cathodique.

10. Composant électronique selon l'une des revendications précédentes, dans lequel la couche de croissance (7) présente une structure amorphe.

Fig. 1

Fig. 2

**Fig. 3**

**Fig. 4**

**Fig. 5**

**Fig. 6**

**FIG. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080105299 A1
- JP 2006337447 A
- EP 1701395 A1
- JP 2003288993 A
- EP 1939954 A2
- EP 2012375 A2